# EUROPÄISCHE PATENTSCHRIFT

(11) **EP 3 701 272 B1**
(45) Veröffentlichungstag und Bekanntmachung des Hinweises auf die Patenterteilung: **30.06.2021**
(21) Anmeldenummer: 18796390.5
(22) Anmeldetag: 24.10.2018
(51) Int. Cl.: G01R 1/04, G01R 11/04, G01R 22/06, H01R 31/08

(54) **ANSCHLUSSLEISTE**
CONNECTION STRIP
BARRETTE DE RACCORDEMENT

(30) Priorität: 25.10.2017 DE 202017106463 U
(43) Veröffentlichungstag der Anmeldung: 02.09.2020
(73) Patentinhaber: Weidmüller Interface GmbH & Co. KG, 32758 Detmold (DE)
(72) Erfinder: BÖNSCH, Matthias, 33659 Bielefeld (DE); DIEKMANN, Torsten, 33818 Leopoldshöhe (DE); KÜPPERS, Bernd, 51149 Köln (DE); STEINMETZ, Klaus, 65439 Flörsheim am Main (DE)
(74) Vertreter: Specht, Peter
(86) Internationale Anmeldenummer: PCT/EP2018/079125
(87) Internationale Veröffentlichungsnummer: WO 2019/081565

(56) Entgegenhaltungen:
- EP-A1- 1 593 975
- EP-A1- 1 612 566
- DE-A1- 2 256 373
- DE-A1- 2 435 414
- DE-A1- 10 344 736
- DE-A1- 19 613 869
- DE-A1-102004 025 164
- DE-A1-102007 046 640
- DE-A1-102008 062 409
- DE-A1-102011 015 697
- DE-A1-102013 101 533
- DE-B3-102004 051 818
- DE-U1-202004 006 077
- DE-U1-202004 010 045

## Beschreibung

Die Erfindung betrifft eine Anschlussleiste für Zähler mit Anschlussvorrichtungen für Stiftkontakte, die von einem zu kontaktierenden Zähler abstehen.

Ein Zähler im Sinne dieser Anmeldung ist ein Stromzähler. Die gattungsgemäßen Anschlussleisten ermöglichen einen Zähleraustausch ohne Unterbrechung der Stromversorgung von Verbrauchern. Dazu sind an die Anschlussleisten Brückungsstecker ansteckbar, welche die zu- und abgehenden Phasen im eingesteckten Zustand so verbinden, dass der Austausch des Zählers ohne Unterbrechung der Stromversorgung möglich wird.

Aus DE10344736A1 und DE102004 051818B3 sind Anschlussvorrichtungen für Stromzähler bekannt, die durch eine verschiebbare, federbelastete Platte berührungssicher sind.

Der vorliegenden Erfindung liegt die Aufgabe zugrunde, eine Anschlussleiste der gattungsgemäßen Art zu schaffen, die auch erhöhten Sicherungsanforderungen insbesondere in Hinsicht auf einen Berührschutz (IP 2X) genügt.

Diese Aufgabe wird durch den Gegenstand des Anspruchs 1 genutzt.

Weitere vorteilhafte Ausgestaltungen der Erfindung sind den Unteransprüchen zu entnehmen.

Anspruch 1 schafft zur Lösung der Aufgabe eine Anschlussleiste für einen Zähler, welche vorteilhaft wenigstens ein bewegliches Gehäuseelement aufweist, das sich bei an die Anschlussleiste angestecktem Zähler in einer ersten Stellung befindet und das sich ohne angesetzten Zähler in einer zweiten Stellung befindet.

Derart wird auf einfacher Weise ein Schutz gegen eine direkte oder indirekte Berührung unter Spannung stehender Teile realisiert.

Weiter wird vorgesehen, dass das bewegliche Gehäuseelement von einem Kraftspeicher mit Kraft beaufschlagt ist, der dazu ausgelegt und angeordnet ist, das bewegliche Gehäuseelement bei einem Abnehmen des Zählers von der Anschlussleiste von der ersten Stellung in die zweite Stellung zu bewegen. Endlich wird das bewegliche Gehäuseelement als Haube ausgestaltet.

Dabei kann der Kraftspeicher nach einer Variante durch eine oder mehrere Federn, bevorzugt Schraubenfedern, gebildet sein, welche vorzugsweise zwischen dem beweglichen Gehäuseelement und dem Gehäuse verteilt sein können.

Nach einer vorteilhaften optionalen Weiterbildung kann vorgesehen sein, dass die Anschlussleiste einen Sicherheits-Ablagestecker für einen oder mehrere Leiter aufweist.

Zudem kann vorteilhaft vorgesehen sein, dass Befestigungsmittel wie Schwalbenschanzvorsprünge und/oder Nuten an dem Gehäuse der Anschlussleiste ausgebildet sind, um dort eine Zusatzeinrichtung wie den erwähnten Sicherheits-Ablagestecker anzuordnen.

Nachfolgend wird die Erfindung unter Bezug auf die Zeichnung anhand von Ausführungsbeispielen näher erläutert, wobei auch weitere Vorteile der Erfindung deutlich werden. Es sei betont, dass das nachfolgend diskutierte Ausführungsbeispiel die Erfindung nicht abschließend beschreiben soll, sondern dass auch nicht dargestellte Varianten und Äquivalente realisierbar sind und unter die Ansprüche fallen. Unbestimmte Artikel wie "ein" sind nicht als Zahlwort, sondern - sofern nicht anders definiert - im Sinne von "wenigstens ein" zu verstehen.

Die Erfindung soll nun anhand von Ausführungsbeispielen und der beiliegenden, sich auf diese Ausführungsbeispiele beziehenden Zeichnungen näher erläutert werden. Es zeigen:
- Fig.1: eine Draufsicht auf eine erste Ausgestaltung einer Anschlussleiste, die an einen Zähler angesteckt ist, wobei sich die Anschlussleiste in einem ersten Zustand befindet und wobei auf sie ein Brückungsstecker aufgesteckt ist;
- Fig. 2: eine Draufsicht auf die Anordnung aus Fig. 1 mit einem nicht an die Anschlussleiste angesteckten - beispielsweise von dieser abgenommenen - Zähler, wobei sich die Anschlussleiste in einem zweiten Zustand befindet;
- Fig. 3: eine perspektivische Ansicht der Anordnung aus Fig. 1 mit einem an die Anschlussleiste angesteckten Zähler und mit einem auf die Anschlussleiste aufgesteckten Brückungsstecker, wobei ein Abnehmen des Zählers begonnen hat;
- Fig. 4: eine Schnittansicht der Anordnung aus Fig. 3 in dem Zustand aus Fig. 3;
- Fig. 5: eine perspektivische Ansicht der Anordnung aus Fig. 3 beim Abnehmen des Zählers und mit einem auf die Anschlussleiste aufgesteckten Brückungsstecker;
- Fig. 6: eine Draufsicht auf die Anordnung aus Fig. 5 in dem Zustand aus Fig. 5;
- Fig. 7: eine Schnittansicht der Anordnung aus Fig. 5 in dem Zustand aus Fig. 5;
- Fig. 8: eine perspektivische Ansicht der Anordnung aus Fig. 3 nach dem Abnehmen des Zählers und mit dem auf die Anschlussleiste aufgesteckten Brückungsstecker;
- Fig. 9: eine Schnittansicht der Anordnung aus Fig. 8 in dem Zustand aus Fig.8;
- Fig. 10: eine Sprengansicht der Anschlussleiste aus Fig. 1 bis 9;
- Fig. 11: eine Sprengansicht einer Kontaktbaugruppe der Anschlussleiste aus Fig. 1 bis 10;
- Fig. 12: eine Seitenansicht auf eine zweite Ausgestaltung einer Anschlussleiste, die an einen Zähler ansteckbar ist, wobei oberhalb der Anschlussleiste ein Brückungsstecker dargestellt ist, der die Anschlussleiste noch nicht kontaktiert;
- Fig. 13: eine perspektivische Ansicht der Anordnung aus Fig. 12;
- Fig. 14: eine erste Schnittansicht der Anordnung aus Fig. 12;

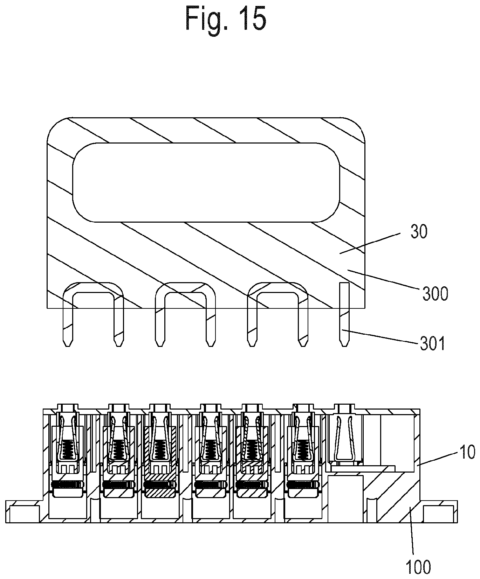

- Fig. 15: eine zweite, relativ zu Fig. 14 um 90° gedrehte Schnittansicht der Anordnung aus Fig. 12, wobei oberhalb der Anschlussleiste wiederum der Brückungsstecker dargestellt ist, der die Anschlussleiste noch nicht kontaktiert;

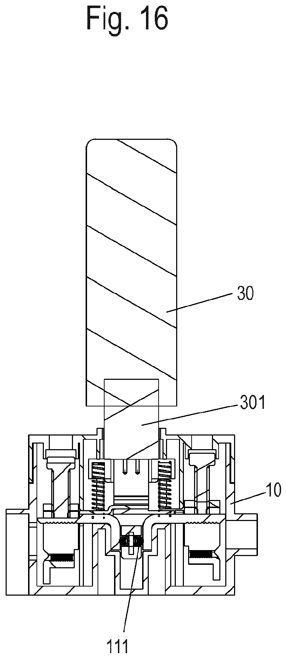

- Fig. 16: die Ansicht aus Fig. 14, wobei der Brückungsstecker an die Anschlussleiste angesetzt ist und diese kontaktiert, aber wobei der Brückungsstecker noch nicht eine Endkontaktstellung erreicht hat;

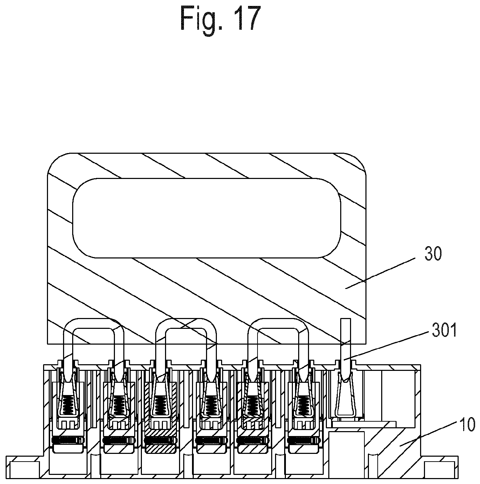

- Fig. 17: die Schnittansicht der Fig. 15 in dem Zustand aus Fig. 16;

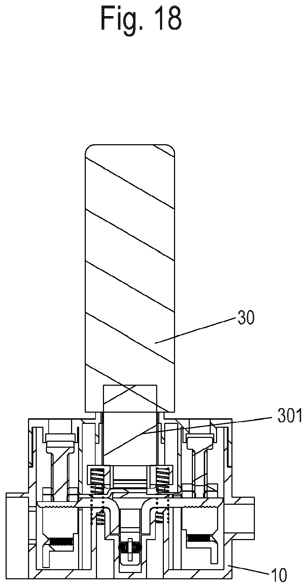

- Fig. 18: die Ansicht aus Fig. 14 und 16, wobei der Brückungsstecker an die Anschlussleiste angesetzt ist und diese kontaktiert, wobei der Brückungsstecker an die Anschlussleiste angesetzt ist und diese kontaktiert und wobei er die Endkontaktstellung erreicht hat;

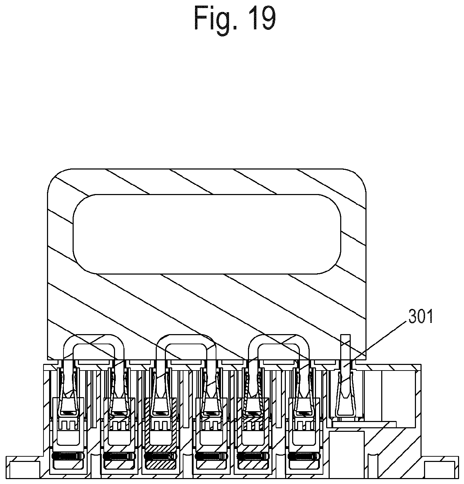

- Fig. 19: die Schnittansicht der Anordnung aus Fig. 17 in dem Zustand aus Fig. 18;

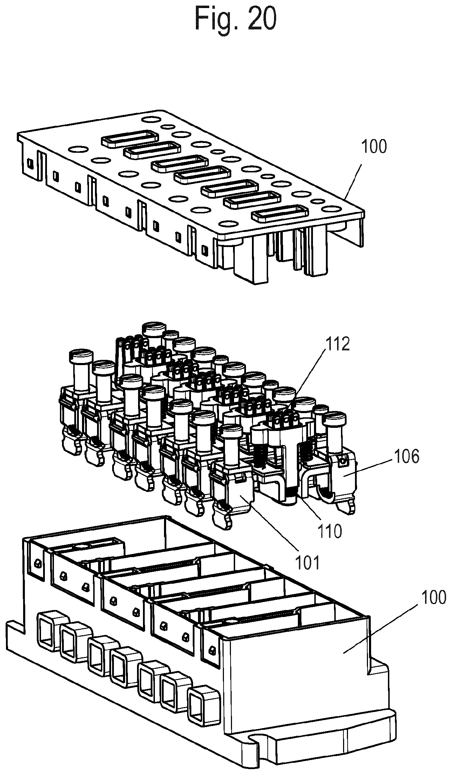

- Fig. 20: eine Sprengansicht der Anschlussleiste aus Fig. 12 bis 19;
- Fig. 21: eine Sprengansicht einer Kontaktbaugruppe der Anschlussleiste aus Fig. 12 bis 20;
- Fig. 22: in a) eine perspektivische Ansicht eines weiteren Zählers, an den einen Anschlussleiste angesteckt ist, die einen Sicherheits-Ablagestecker aufweist und in b) einen Ausschnitt "A" aus a) in vergrößerter Darstellung;

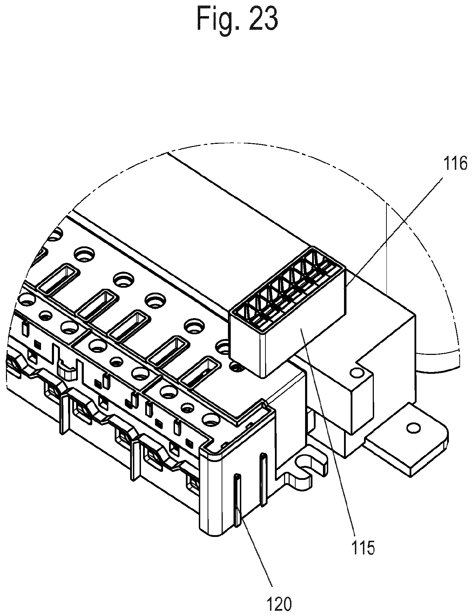

- Fig. 23: den Ausschnitt "A" aus Fig. 22 a) während eines Ansteckens des Sicherheits-Ablagesteckers;

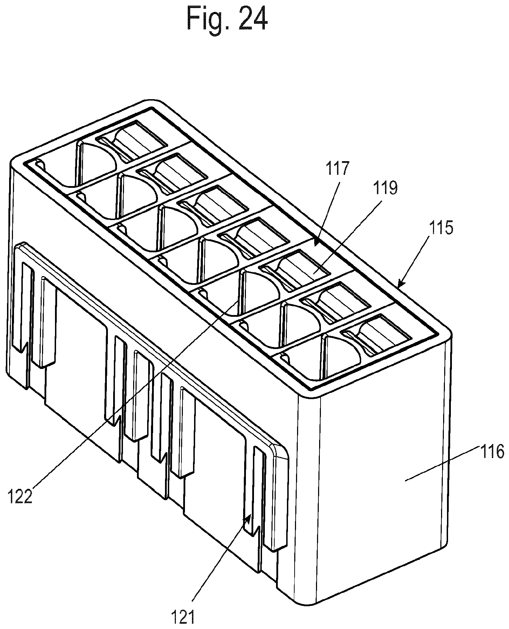

- Fig. 24: eine vergrößerte Darstellung des Sicherheits-Ablagesteckers aus Fig. 22 und 23;

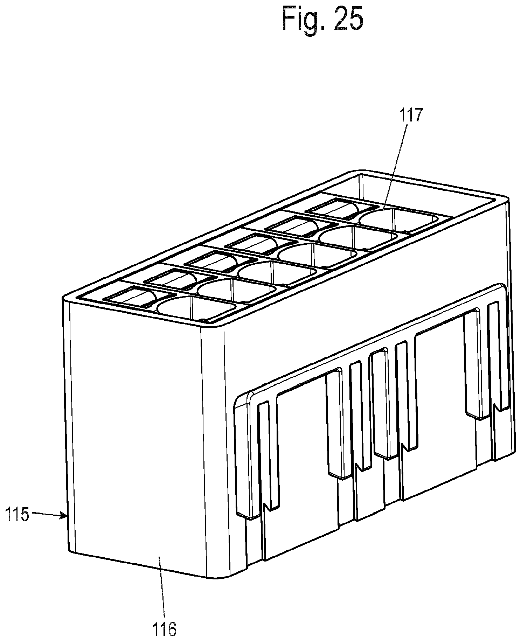

- Fig. 25: den Sicherheits-Ablagestecker aus Fig. 24 vor dem Einstecken einer mehrerer Anschlussscheiben; und
- Fig. 26: in a) und b) verschiedene perspektivische Ansichten einer Anschlussscheibe für den Sicherheits-Ablagestecker aus Fig. 25.

Begriffe wie "oben", "unten", "rechts" oder "links" beziehen sich auf die jeweilige dargestellte Position in den Figuren und sind bei Bewegungen - insbesondere Drehungen - der dargestellten Elemente im Raum relativ zu verstehen bzw. zu betrachten.

In den Figuren bezeichnet das Bezugszeichen 10 eine Anschlussleiste, das Bezugszeichen 20 einen (schematisch dargestellten) Zähler, insbesondere einen Stromzähler, und das Bezugszeichen 30 einen Brückungsstecker 30.

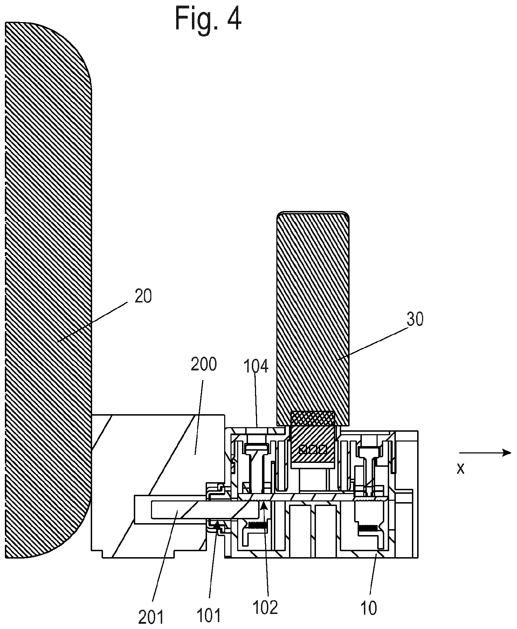

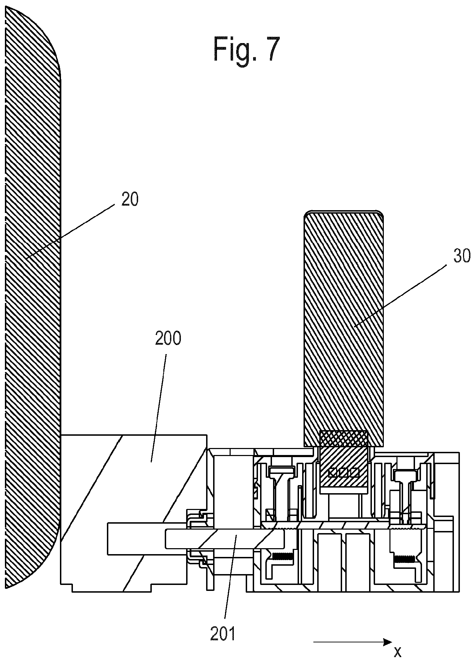

Der Zähler 20 weist eine Gehäuse 200 auf, aus dem Stiftkontakte 201 vorstehen (siehe Fig. 4 und 7). Die Anschlussleiste 10 weist ein vorzugsweise aus einem elektrisch isolierenden Kunststoff bestehendes Gehäuse 100 auf, das eine Leistenform hat. Das Gehäuse 100 weist an seiner dem Zähler 20 zugewandten Seite Öffnungen 101 auf und den Öffnungen zugeordnete zählerseitige erste Anschlussvorrichtungen 102 für Leiter, die als Klemmanschlüsse ausgebildet sein können.

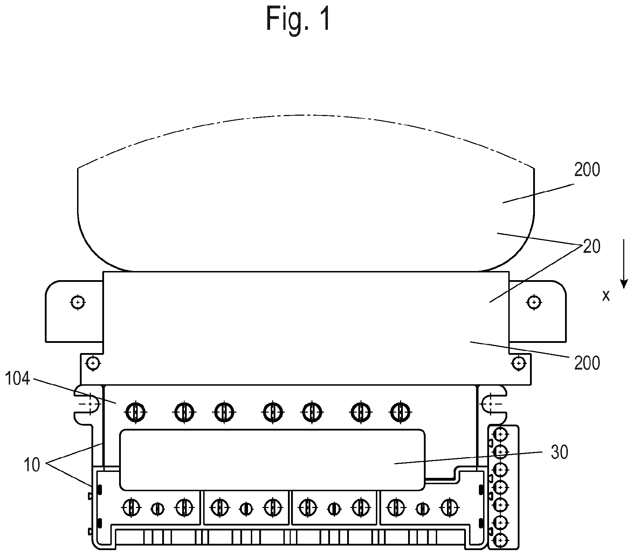

Die Stiftkontakte 201 sind in einer ersten Richtung X in die Anschlussvorrichtungen 102 der Anschlussleiste 10 einsteckbar und in Fig. 1 auch eingesteckt.

Bei einem Wechsel des Zählers wird der Brückungsstecker 30 auf die Anschlussleiste 10 aufgesteckt, um bei dem Wechsel des Zählers 20 einen unterbrechungsfreien Betrieb zu gewährleisten. Zur Erleichterung des Verständnisses dieser elektrischen Funktionalität wird beispielsweise auf die DE 102 16 913 A verwiesen.

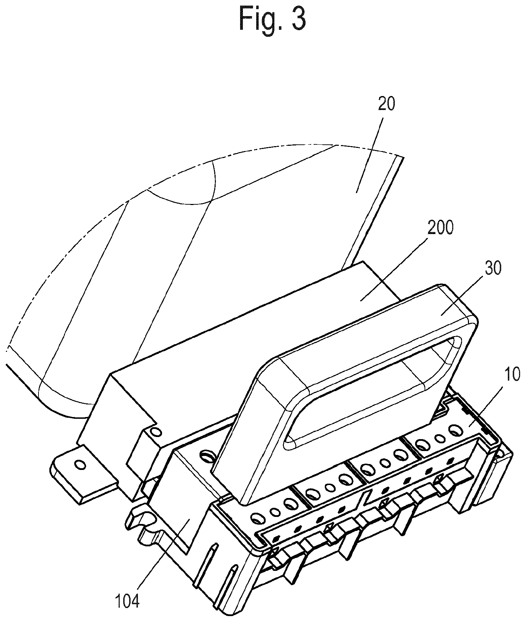

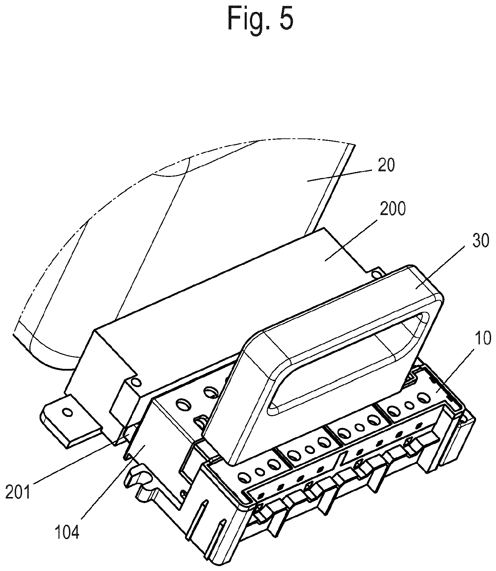

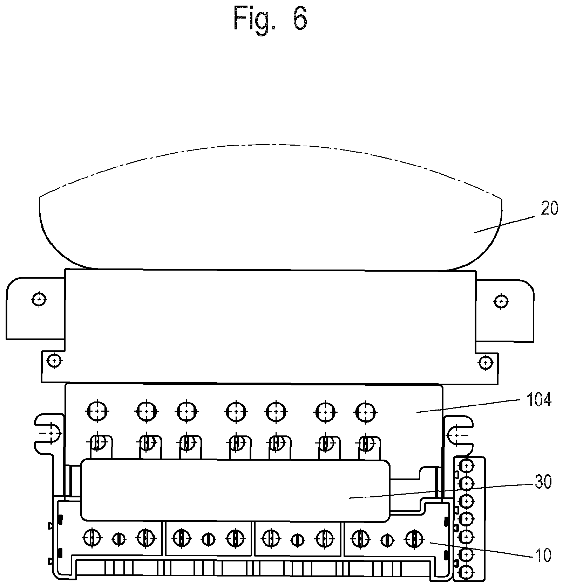

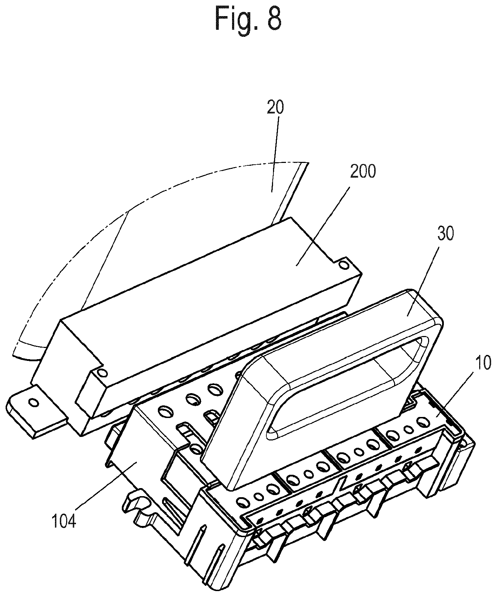

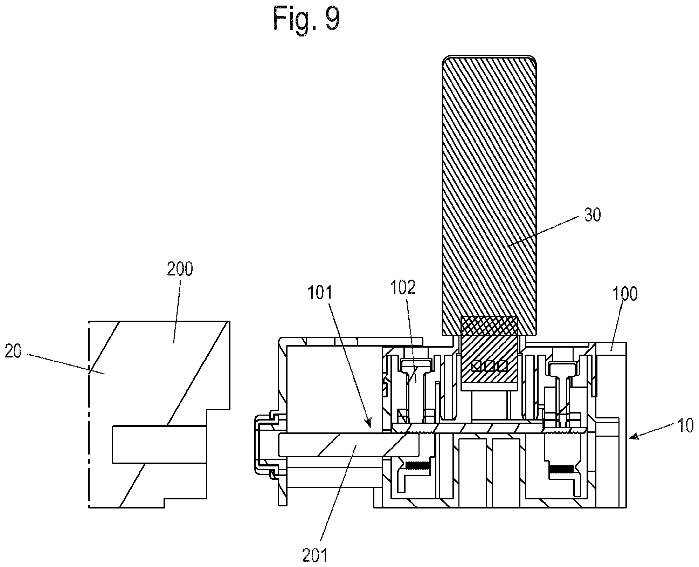

Nach dem Ausführungsbeispiel der Anschlussleiste 10 und des Zählers 20 der Fig.1 bis 9 stehen die Stiftkontakte 201 dabei solange, bis der Zähler vollständig aus den zählerseitigen ersten Anschlussvorrichtungen 102 für Leiter gelöst ist, unter Spannung.

Zur Lösung dieses Problems ist an dem Gehäuse 100 ein bewegliches Gehäuseelement 104 angeordnet. Diesem bewegliche Gehäuseelement 104 ist ein Kraftspeicher zugeordnet, der dazu ausgelegt und angeordnet ist, das bewegliche Gehäuseelement 104 bei einem Abnehmen des Zählers von der Anschlussleiste 10 von einer ersten Position eine zweite Position zu bewegen.

Der Kraftspeicher kann durch eine oder mehrere Federn 105 gebildet sein. Das bewegliche Gehäuseelement 104 ist als Haube ausgestaltet. Die eine oder mehreren Federn 105 sind zwischen dem beweglichen Gehäuseelement 104 und dem Gehäuse 100 verteilt. Die Federn 105 können als Schraubenfedern ausgebildet sein.

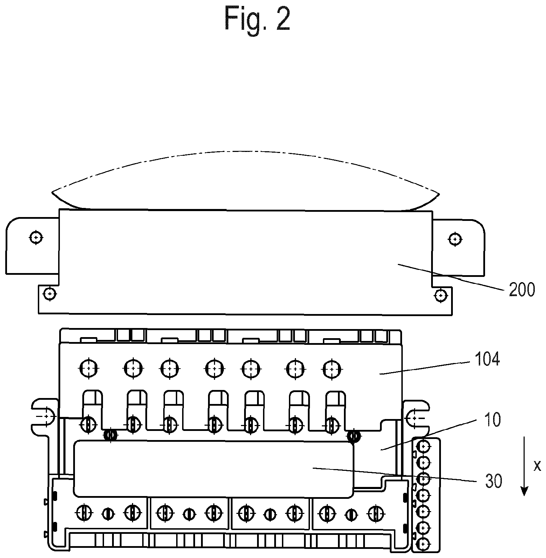

In der Position der Fig. 1, in welcher der Zähler 20 vollständig an die Anschlussleiste 102 angesetzt ist und in der Stiftkontakte 201 der ersten Richtung X maximal in die Anschlussvorrichtungen 102 der Anschlussleiste 10 eingesteckt sind, ist das bewegliche Gehäuseelement nahe an das Gehäuse 100 heranbewegt. Die Federn 105 befinden sich in einer komprimierten Position. Wird nun der Zähler 20 abgenommen (Fig.2), werden entweder die Stiftkontakte 201 entgegen der ersten Richtung X aus den Anschlussvorrichtungen 102 der Anschlussleiste 10 herausgezogen. Dabei entspannen sich die Federn und bewegen damit das bewegliche Gehäuseelement 104. Oder die Stiftkontakte 201 verbleiben an der Anschlussleiste 10 und werden aus dem Zähler 20 gelöst. Auch dann entspannen sich die Federn 105 und bewegen damit das bewegliche Gehäuseelement 104.

Das Gehäuseelement 104 ist derart ausgelegt und angeordnet und von dem Kraftspeicher beaufschlagt, dass es sich beim Abnehmen des Zählers über die Stiftkontakte 201 des Zählers 20 bewegt. Insbesondere ist diese Bewegung derart, dass durch das hier verschiebeartige Ausfahren des Gehäuseelementes 104 in keinem Moment eine Gefahr besteht, die Kontaktstifte 201 von oben oder der Seite - dort, wo das Gehäuseteil 104 schützend vorgesehen ist - mit dem Finger zu berühren.

Das bewegliche Gehäuseelement kann auch mittels Schrauben (ggf. kann dann eine Verwendung von Werkzeug erforderlich sein) in dieser Position arretiert werden (nicht dargestellt). Hiermit kann auch ein zusätzlicher Schutz realisiert werden, der ein unbeabsichtigtes oder unbefugtes Herunterdrücken des beweglichen Teils verhindert. Ansonsten kann das bewegliche Gehäuseteil aber auch auf andere Weise gesichert sein, so z.B. durch ausreichende Federkraft. Derart kann auf einfache Weise ein Schutz gemäß Schutzklasse IP2XC gewährleistet werden.

Das bewegliche Gehäuseelement 104 wird nach Art einer Haube mehrere Seitenwände aufweisen und derart in mehrere Richtungen Schutz bieten.

Mit dem beweglichen, von dem Kraftspeicher mit Kraft beaufschlagten Gehäuseelement 104 wird in vorteilhafter Weise eine Anschlussleiste 10 für Zähler geschaffen, die auch erhöhten Sicherungsanforderungen insbesondere in Hinsicht auf einen Berührschutz (IP 2X) genügt.

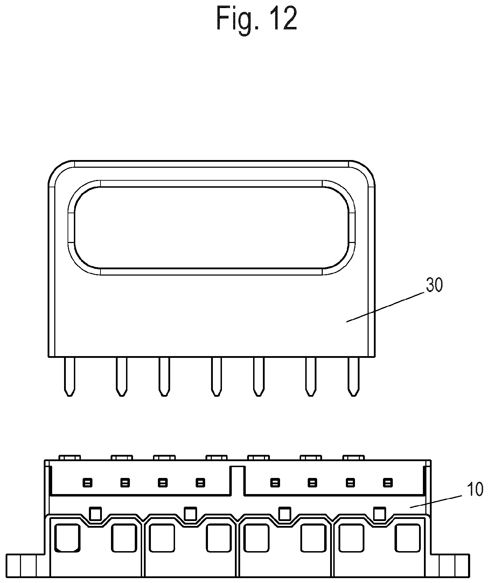

Nach Fig. 12 ff. wird eine alternative Lösung verwirklicht.

Auf der dem Zähler 20 abgewandten Seite sind hier wiederum an die Anschlussleiste 10 jeweils Leiter für die Zu- und Rückleitung von hier drei Spannungsphasen und vorzugsweise eines Nullleiters anschließbar. Auf der dem Zähler 20 zugewandten Seite weist das Gehäuse 100 daher insgesamt sieben der Öffnungen 101 für die von dem Zähler 10 vorstehenden Stiftkontakte auf.

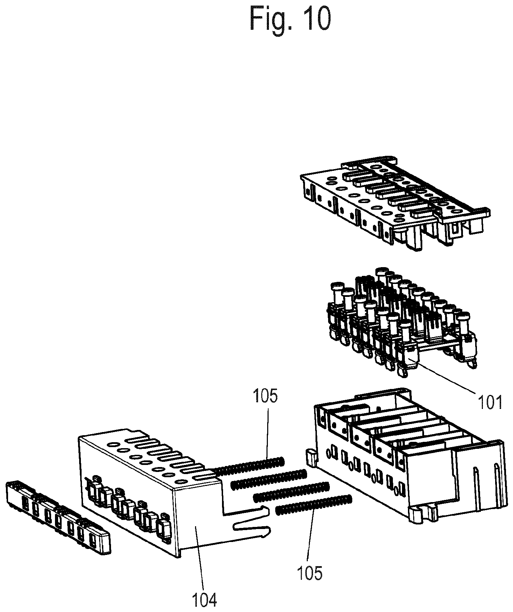

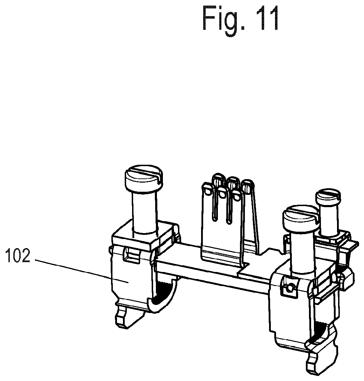

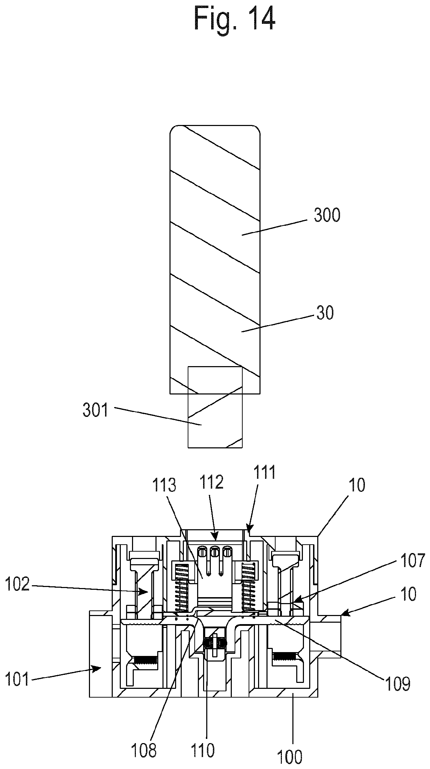

Die gleiche Zahl von Öffnungen 106 kann an dem Gehäuse 100 an dessen von dem Zähler 1 abgewandten Seite vorgesehen sein. Es sind hier weitere, zweite Anschlussvorrichtungen 107 vorgesehen, die zum Anschluss der Kabel vorgesehen sind (siehe insbesondere Fig. 14). Soweit stimmen die Ausführungsbeispiele der Fig. 1 bis 12 und der Fig. 13 ff. noch technisch überein.

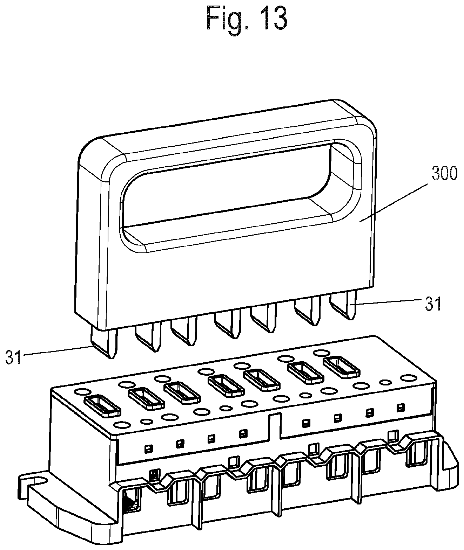

Die ersten Anschlussvorrichtungen 102 und die zweiten Anschlussvorrichtungen 107 sind jeweils in dem Gehäuse 100 der Anschlussleiste 10 über einen oder mehrere Stromschienenabschnitte 108, 109 verbunden. Nach Fig. 13 ff sind die zwei Stromschienenabschnitte 108, 109 zudem über einen lösbaren Federkontakt 110 leitend miteinander verbunden.

Die Anschlussvorrichtungen 101 und 107 können jeweils als Klemmanschlüsse, insbesondere als Schraubanschlüsse ausgebildet sein.

Die Stromschienenabschnitte 108, 109 sind hier in einer Seitenansicht jeweils L-förmig.

Für den Brückungsstecker 30 sind an der Oberseite des Gehäuses weitere Öffnungen 111 ausgestaltet. Jeder der Öffnungen 111 ist eine dritte Anschlussvorrichtung 112 zugeordnet. Diese bzw. vorzugsweise jede dritte Anschlussvorrichtung 112 kann als ein erster Steckkontakt 113 - beispielsweise als ein Buchsenkontakt - ausgebildet sein.

Der Brückungsstecker 30 ist so ausgestaltet, dass er an einem Gehäuse 300 für jede der zu- und abgehenden und zu brückenden Phasen und vorzugsweise den Neutralleiter jeweils einen korrespondierenden zweiten Steckkontakt 301 - insgesamt also insbesondere sieben zweite Steckkontakte 301 - aufweist.

Wird der Brückungsstecker 30 auf das Gehäuse 100 der Anschlussleiste 10 aufgesetzt und die zweiten Steckkontakte 301 des Brückungssteckers 30 werden in das Gehäuse 100 der Anschlussleiste 10 in die ersten Steckkontakte 113 eingesteckt, verbindet er leitend die zu- und abgehenden jeweiligen Phasen und vorzugsweise den zu- und abgehenden Neutralleiter. Derart kann der Zähler 20 gewechselt werden, ohne dass die Spannungsversorgung von Verbrauchern unterbrochen werden muss.

Dabei ist die dritte Anschlussvorrichtung 112 weiter derart ausgestaltet, dass bei dem Einstecken der Steckkontakte 301 des Brückungssteckers 30 die Steckkontakte 113 der dritten Anschlußvorrichtung 112 nach Erreichen eines Zustands, in dem die korrespondierenden Stromschienen der zu- und abgehenden Phasen und ggf. des Neutralleiters bereits leitend miteinander "brückend" verbunden sind, der jeweilige Federkontakt 110 an der dritten Anschlußvorrichtung 112, der die zwei Stromschienenabschnitte 107 , 108 jeweils leitend verbindet, gelöst wird. Damit sind die beiden Stromschienen 106, 107 nicht mehr leitend miteinander verbunden.

Damit sind auch die Stiftkontakte 201 des Zählers/zu dem Zähler in den ersten Anschlussvorrichtungen 102 an dem Zähler 10 spannungsfrei.

Der Federkontakt 110 lässt sich auf verschiedene Weise realisieren.

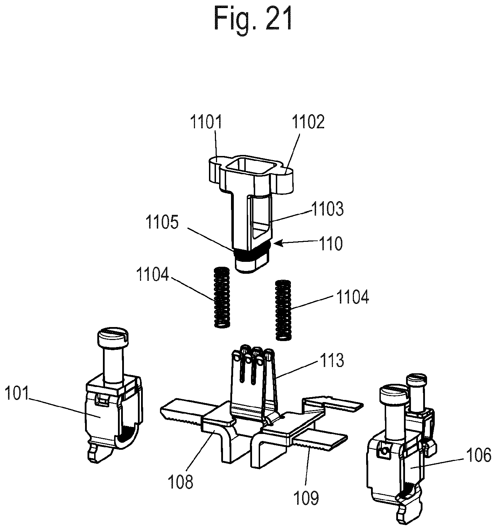

Nach Fig. 21 weist er eine T-Form mit zwei Querschenkeln 1101 und 1102 und eine Längsschenkel 1103 auf. Zwischen den Querschenkeln 1101 und 1102 und dem Längsschenkel 1103 sind eine oder mehrere Federn 1104 verteilt. Diese drücken den Federkontakt 110 in eine in Fig. 13 ff. obere Position, in dem eine an dem Längsschenkel 1103 ausgebildete Kontaktanordnung, insbesondere Federanordnung, 1105 aus elektrisch gut leitendem Material die zwei Stromschienen 107, 108, die zu der ersten bzw. der zweiten Anschlussvorrichtung der Anschlussleiste 10 führen, leitend miteinander verbinden. Der übrige Bereich des t-förmigen Federkontaktes kann aus elektrisch isolierendem Material wie Kunststoff bestehen. Wird nun der Steckkontakt 301 des Brückungssteckers 30 aufgesetzt, drückt er den zugehörigen Federkontakt 110 gegen die Kraft der Feder(n) 1104 nach unten. Der Federkontakt 110 ist so gestaltet und bemessen, dass erst nach Kontaktschluss der Steckkontakte 301 am Brückungsstecker 30 mit den dritten Anschlussvorrichtungen 113 der elektrische Kontakt zwischen den Stromschienenabschnitten 108, 109 gelöst wird.

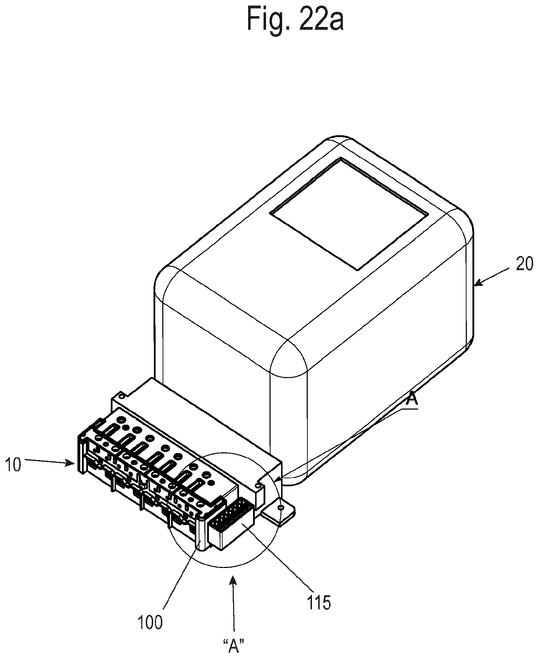

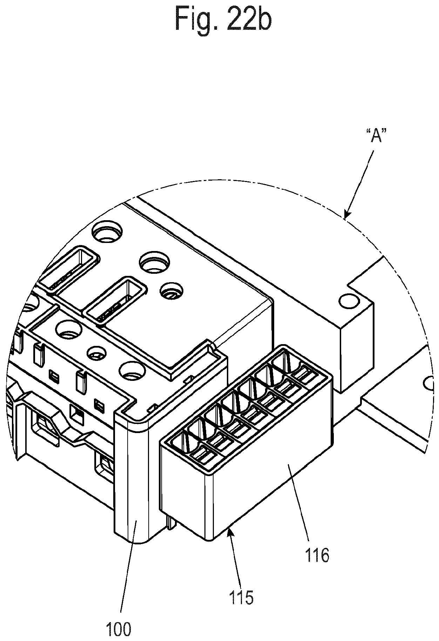

Fig. 22a) zeigt eine perspektivische Ansicht eines weiteren Zählers 20, an den einen Anschlussleiste 10 angesteckt ist. Diese Anschlussleiste 10 kann eine oder mehrere Merkmale der vorstehenden Figuren aufweisen und nach Art eines oder mehrerer der Ansprüche ausgestaltet sein.

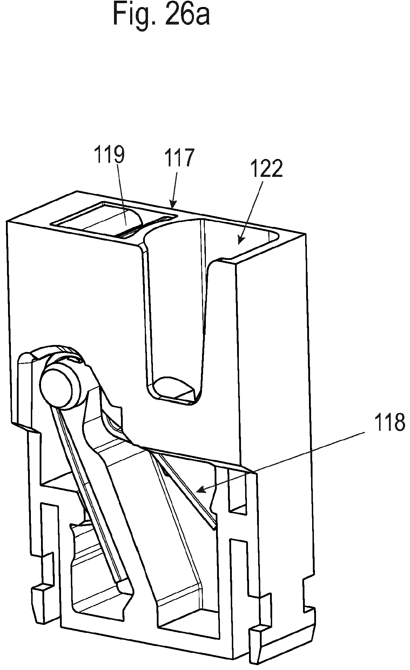

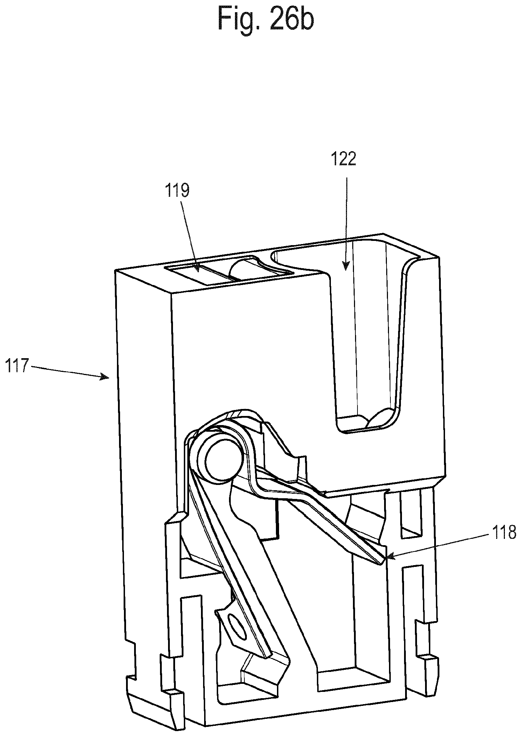

Die Anschlussleiste zudem wieder das Gehäuse 100 auf. An dieses Gehäuse 100 ist hier ein Sicherheits-Ablagestecker 115 für Leiter angesetzt oder angeformt. Der Sicherheits-Ablagestecker 115 weist ein Gehäuse 116 auf. In dem Gehäuse 116 sind direkt oder an Einschiebescheiben 117 (siehe auch Fig. 26a, b), die in das an vorzugsweise einer Seite offene Gehäuse 116 einsetzbar sind, Anschlussvorrichtungen 118 für Leiter ausgebildet. Diese liegen gegen Berührung durch Finger geschützt im inneren des Gehäuses 116 und sind - nur für die Leiterenden - durch entsprechend dimensionierte Öffnungen 122 direkt im Gehäuse 116 oder in den Einschiebescheiben 117 zugänglich. Nach einer bevorzugten Variante können diese Anschlussvorrichtungen 118 als Direktsteckanschlüsse ausgebildet sein, beispielsweise als Push-In-Anschlüsse, die eine Druckfeder aufweisen. Diese Anschlussvorrichtungen 118 können ferner mit einem Betätigungsmittel wie einem Drücker 119 in eine Offenstellung versetzt werden, um einen jeweiligen Leiter einzuführen oder zu lösen. Sind die Leiter nicht feindrähtig, ist es in der Regel auch möglich, sie direkt in den jeweiligen Direktsteckanschluss einzustecken.

Derart ist es auf einfache Weise möglich, während Wartungs- oder Reparatur- oder Austauscharbeiten am Zähler 20 einen oder mehrere Leiter, die an den Zähler 20 oder die Anschlussleiste 10 anzuschließen sind, mit einem Ende, insbesondere mit einem abisolierten Ende, in einen der Direktsteckanschlüsse einzuführen, so dass der abisolierte Teil innerhalb des Gehäuses 116 des Sicherheits-Ablagesteckers 115 liegt. Derart wird direkt an der Anschlussleiste 10 durch den Sicherheits-Ablagestecker 115 eine einfache Möglichkeit dazu geschaffen, abisolierte Leiterenden bzw. Drahtenden sicher unterzubringen, ohne das die Gefahr besteht, sie mit der Hand zu berühren. Derart wird auf einfache Weise eine Tarifdrahthaltefunktion realisiert.

Um den Sicherheits-Ablagestecker 115 an das Gehäuses ansetzen zu können, können korrespondierende Befestigungsmittel wie beispielsweise Schwalbenschanzvorsprünge 120 und Nuten 121 an den Gehäusen 100 und 116 ausgebildet sein.

**Bezugszeichen**

| | |
|---|---|
| Anschlussleiste | 10 |
| | |
| Gehäuse | 100 |
| Öffnungen | 101 |
| erste Anschlussvorrichtungen | 102 |
| bewegliches Gehäuseelement | 104 |
| Federn | 105 |
| Öffnungen | 106 |
| zweite Anschlussvorrichtungen | 107 |
| Stromschienenabschnitte | 108, 109 |
| Federkontakt | 110 |
| Öffnungen | 111 |
| dritte Anschlussvorrichtung | 112 |
| erster Steckkontakt | 113 |
| Sicherheits-Ablagestecker | 115 |
| Gehäuse | 116 |
| Einschiebescheiben | 117 |
| Anschlussvorrichtungen | 118 |
| Drücker | 119 |
| Schwalbenschanzvorsprünge | 120 |
| Nuten | 121 |
| Öffnungen | 122 |
| | |
| Querschenkel | 1101 und 1102 |
| Längsschenkel | 1103 |
| Federn | 1104 |
| Federanordnung | 1105 |
| | |
| Zähler | 20 |
| Gehäuse | 200 |
| Stiftkontakte | 201 |
| | |
| Brückungsstecker | 30 |
| zweiter Steckkontakt | 301 |

## Patentansprüche

1. Anschlussleiste (10) für einen Zähler (20), welche wenigstens ein bewegliches Gehäuseelement (104) aufweist, das sich bei an die Anschlussleiste (10) angestecktem Zähler (20) in einer ersten Stellung befindet und das sich ohne angesetzten Zähler (20) in einer zweiten Stellung befindet, wobei das bewegliche Gehäuseelement (104) von einem Kraftspeicher mit Kraft beaufschlagt ist, der dazu ausgelegt und angeordnet ist, das bewegliche Gehäuseelement (104) bei einem Abnehmen des Zählers (20) von der Anschlussleiste (10) von der ersten Stellung in die zweite Stellung zu bewegen, **dadurch gekennzeichnet, dass** das bewegliche Gehäuseelement (104) als eine Haube ausgestaltet ist.

2. Anschlussleiste (10) nach Anspruch 1, **dadurch gekennzeichnet, dass** der Kraftspeicher durch eine oder mehrere Federn (105), bevorzugt Schraubenfedern, gebildet ist.

3. Anschlussleiste (10) nach Anspruch 2, **dadurch gekennzeichnet, dass** die eine oder mehreren Federn (105) zwischen dem beweglichen Gehäuseelement (104) und dem Gehäuse (100) verteilt sind.

4. Anschlussleiste (10) nach einem der vorstehenden Ansprüche, **dadurch gekennzeichnet, dass** die Anschlussleiste (10) einen Sicherheits-Ablagestecker (115) für einen oder mehrere Leiter aufweist.

5. Anschlussleiste (10) nach einem der vorstehenden Ansprüche, **dadurch gekennzeichnet, dass** die Anschlussleiste (10) ein Gehäuse (100) aufweist.

6. Anschlussleiste (10) nach Anspruch 5, **dadurch gekennzeichnet, dass** der Sicherheits-Ablagestecker (115) ein Gehäuse (116) aufweist, dass an das Gehäuse (100) angesetzt oder angeformt ist.

7. Anschlussleiste (10) nach Anspruch 6, **dadurch gekennzeichnet, dass** in dem Gehäuse (116) direkt oder an Einschiebescheiben (117), die in das an vorzugsweise einer Seite offene Gehäuse (116) einsetzbar sind, Anschlussvorrichtungen (118) für Leiter ausgebildet sind, die gegen Berührung durch Finger geschützt liegen und für die Leiter durch Öffnungen (122) direkt im Gehäuse (116) oder in den Einschiebescheiben (117) zugänglich sind.

8. Anschlussleiste (10) nach Anspruch 7, **dadurch gekennzeichnet, dass** korrespondierende Befestigungsmittel wie Schwalbenschanzvorsprünge (120) und Nuten (121) an den Gehäusen (100) und (116) ausgebildet sind.

9. Anschlussleiste (10) nach einem der vorstehenden Ansprüche, **dadurch gekennzeichnet, dass** Befestigungsmittel wie Schwalbenschanzvorsprünge (120) und/oder Nuten (121) an dem Gehäuse (100) der Anschlussleiste (10) ausgebildet sind, um dort eine Zusatzeinrichtung anzuordnen.

10. Anschlussleiste (10) nach einem der vorstehenden Ansprüche mit einem daran angesteckten Zähler (20).

## Claims

1. Connection strip (10) for a counter (20), which has at least one movable housing element (104) which is located in a first position when the counter (20) is connected to the connection strip (10) and which is located in a second position when the counter (20) is not connected, wherein the movable housing element (104) is acted upon by force from an energy storage device, which is designed and arranged to move the movable housing element (104) from the first position into the second position when the counter (20) is removed from the connection strip (10), **characterized in that** the movable housing element (104) is designed as a hood.

2. Connection strip (10) according to claim 1, **characterized in that** the energy storage device is formed by one or more springs (105), preferably helical springs.

3. Connection strip (10) according to claim 2, **characterized in that** the one or more springs (105) are distributed between the movable housing element (104) and the housing (100).

4. Connection strip (10) according to one of the preceding claims, **characterized in that** the connection strip (10) has a safety storage plug (115) for one or more conductors.

5. Connection strip (10) according to one of the preceding claims, **characterized in that** the connection strip (10) comprises a housing (100).

6. Connection strip (10) according to claim 5, **characterized in that** the safety storage plug (115) has a housing (116) that is attached to or integrally formed on the housing (100).

7. Connection strip (10) according to claim 6, **characterized in that** connection devices (118) for conductors are formed in the housing (116) directly or on insertion discs (117), which can be inserted into the housing (116) which is open preferably on one side, which connection devices (118) are located protected against contact by fingers and are accessible for the conductors through openings (122) directly in the housing (116) or in the insertion discs (117).

8. Connection strip (10) according to claim 7, **characterized in that** corresponding fastening means such as dovetail projections (120) and grooves (121) are formed on the housings (100) and (116).

9. Connection strip (10) according to one of the preceding claims, **characterized in that** fastening means such as dovetail projections (120) and/or grooves (121) are formed on the housing (100) of the connection strip (10) in order to arrange an additional device there.

10. Connection strip (10) according to one of the preceding claims having a counter (20) plugged into it.

## Revendications

1. Barrette de raccordement (10) pour un compteur (20), comprenant au moins un élément de boîtier mobile (104) qui se trouve dans une première position quand le compteur (20) est enfiché sur la barrette de raccordement (10) et qui se trouve dans une deuxième position quand il n'y a pas de compteur (20) posé dessus, dans laquelle l'élément de boîtier mobile (104) est soumis à la force d'un accumulateur de force qui est conçu et disposé pour déplacer l'élément de boîtier mobile (104) de la première position à la deuxième quand le compteur (20) est enlevé de la barrette de raccordement (10), **caractérisée en ce que** l'élément de boîtier mobile (104) est conformé comme un capuchon.

2. Barrette de raccordement (10) selon la revendication 1, **caractérisée en ce que** L'accumulateur de force est formé par un ou plusieurs ressorts (105), de préférence des ressorts hélicoïdaux.

3. Barrette de raccordement (10) selon la revendication 2, **caractérisée en ce que** les un ou plusieurs ressorts (105) sont répartis entre l'élément de boîtier mobile (104) et le boîtier (100).

4. Barrette de raccordement (10) selon l'une des revendications précédentes, **caractérisée en ce que** la barrette de raccordement (10) présente un connecteur de rangement de sécurité (115) pour un ou plusieurs conducteurs.

5. Barrette de raccordement (10) selon l'une des revendications précédentes, **caractérisée en ce que** la barrette de raccordement (10) présente un boîtier (100).

6. Barrette de raccordement (10) selon la revendication 5, **caractérisée en ce que** le connecteur de rangement de sécurité (115) présente un boîtier (116) qui est posé ou formé sur le boîtier (100).

7. Barrette de raccordement (10) selon la revendication 6, **caractérisée en ce que** sont formés dans le boîtier (116), directement ou sur des plaques d'insertion (117) qui peuvent être insérées dans le boîtier (116) ouvert de préférence sur un côté, des dispositifs de raccordement (118) pour des conducteurs qui sont protégés contre le contact des doigts et qui sont accessibles aux conducteurs à travers des ouvertures (122) formées directement dans le boîtier (116) ou dans les plaques d'insertion (117).

8. Barrette de raccordement (10) selon la revendication 7, **caractérisée en ce que** des moyens de fixation en correspondance tels que des saillies en queue d'aronde (120) et des rainures (121) sont formés sur les boîtiers (100) et (116).

9. Barrette de raccordement (10) selon l'une des revendications précédentes, **caractérisée en ce que** des moyens de fixation tels que des saillies en queue d'aronde (120) et des rainures (121) sont formés sur le boîtier (100) de la barrette de raccordement (10) pour y disposer un dispositif supplémentaire.

10. Barrette de raccordement (10) selon l'une des revendications précédentes avec un compteur (20) enfiché dessus.
